# EUROPEAN PATENT SPECIFICATION

(11) **EP 3 520 589 B1**
(45) Date of publication and mention of the grant of the patent: **22.04.2020**
(21) Application number: 17784198.8
(22) Date of filing: 27.09.2017
(51) Int. Cl.: H05K 7/20, H01L 23/367, H01L 23/40, H05K 5/00

(54) **DEVICE AND DISASSEMBLY METHOD.**
VORRICHTUNG UND DEMONTAGEVERFAHREN
DISPOSITIF ET PROCÉDÉ DE DÉMONTAGE

(30) Priority: 29.09.2016 EP 16191286
(43) Date of publication of application: 07.08.2019
(73) Proprietor: Signify Holding B.V., 5656 AE Eindhoven (NL)
(72) Inventor: WENDT, Matthias, 5656 AE Eindhoven (NL); RADERMACHER, Harald, Josef, Günther, 5656 AE Eindhoven (NL); BUDDE, Wolfgang, Otto, 5656 AE Eindhoven (NL)
(74) Representative: Verweij, Petronella Daniëlle
(86) International application number: PCT/EP2017/074447
(87) International publication number: WO 2018/060222

(56) References cited:
- EP-A1- 0 927 990
- JP-A- 2001 263 320

## Description

### FIELD OF THE INVENTION

The present invention relates to a device comprising an assembly of components including a first component and a second component; and a fixing member fixing the first component to the second component.

The present invention further relates to a method of disassembling such a device.

### BACKGROUND OF THE INVENTION

The circular economy is a generic term for an industrial economy that is producing no waste and pollution, by design or intention and as such contrasts the traditional model of a linear economy based on a "take, make, dispose" model of production. The circular economy model of production is desirable to achieve a more sustainable way of producing goods and products, for example by allowing the reuse or recycling of many components of a product that has reached its end of life. This is sometimes referred to as cradle-to-cradle design of such a product.

However, a challenge in achieving such environmentally friendly product designs is the cost associated with the disassembly of such products. For example, a lighting device such as a luminaire may comprise an assembly of a plurality of components, e.g. housing components and active components within the housing, which may be held together by fixing members such as glue or screws, which fixing members may be time consuming to remove if such removal is at all possible; for example, where such fixing members have weathered or are otherwise damaged in case of screws for instance, their removal may have become cumbersome or even impossible. In such scenarios, disassembly of the lighting device to facilitate reuse of at least some of its components may be cost-prohibitive, causing the lighting device to be disposed of, thereby undesirably adding reusable components to the waste stream.

WO 2012/049599 A2 discloses a connector arrangement of a luminaire in which the connector arrangement mechanically connects parts of the luminaire assembly using a soluble material, which may be dissolved in a suitable solvent in order to separate the parts of the assembly, thereby facilitating reuse of such parts. However, in some scenarios the use of a solvent may be impractical or undesirable. For example, in case of a weatherproof housing of a lighting device, the soluble material may have to be positioned inside the housing such that it may be difficult to dissolve the material. Also, such solvents may add to the cost of a disassembly process of such luminaires.

JP 2001/263320 discloses a snap fit coupling structure capable of disassembling a casing without using a tool such as a screw driver. The snap fit coupling structure has a claw part and a claw locking part that are engaged with each other. The claw part or the claw locking part is formed of a material with opposite surfaces having different coefficients of linear expansion.

EP 0927990 discloses a latching apparatus of a hard disk drive using a bimetal member. The apparatus includes locking/releasing means for selectively locking/releasing an actuator for protecting a magnetic disk from being damaged by a magnetic head. The apparatus further includes a bimetal member for operating the locking/releasing means by heat expanding and shrinking according to whether an electric power is applied or not. The apparatus also includes heating means for operating the bimetal member.

### SUMMARY OF THE INVENTION

The present invention seeks to provide a device such as for example a lighting device that may be easily disassembled.

The present invention further seeks to provide a method of disassembling such a device.

According to an aspect, there is provided a device comprising an assembly of components including a first component and a second component, wherein the first component and the second component are housing components of the device. The device further comprises a fixing member adapted to fix the first component to the second component, wherein the fixing member comprises a section deformable by thermal radiation such that the first component is releasable from the second component upon deformation of said section. The device also comprises a circuit arrangement arranged to deliver the thermal radiation to the section.

The present invention is based on the insight that materials exist that may deform upon application of thermal radiation such as heat. Therefore, fixing members formed of or comprising such materials may be used to secure components of a device against each other to assemble the device (or parts thereof) in such a manner that such a fixing arrangement is disrupted by deformation of the fixing member being exposed to sufficient levels of such thermal radiation.

For example, the fixing member may be mounted on the first component and may include a terminal clamping member for engaging with the second component and wherein the section may be an intermediate section of the fixing member such that its deformation is adapted to cause the clamping member to disengage from the second component due to a change in the overall shape of the fixing member caused by the deformation of said section. Such change in the overall shape of the fixing member may cause the engagement between the terminal clamping member and the second component to be disrupted, thereby facilitating the release of the second component from the first component.

The thermal radiation may be delivered to the device by a source of such thermal radiation, e.g. a heating device, , external to the device. However, the device comprises a circuit arrangement arranged to deliver the thermal radiation to the section such that a self-contained disassembly enablement is provided with the device. Such a circuit arrangement in some embodiments may be spatially separated from the section or in alternative embodiments may be in physical contact with the section, for example wound around the section.

The circuit arrangement may be dedicated to delivering the thermal radiation during disassembly of the device although this may add to the overall cost of the device. For this reason, the circuit arrangement preferably has a first mode of operation in which the circuit arrangement is adapted to deliver at least part of the functionality of the device and a second mode of operation in which the circuit arrangement is adapted to deliver the thermal radiation to the section.

In an embodiment, the circuit arrangement is exposed to a higher voltage in the second mode of operation compared to the first mode of operation in order to trigger the generation of (an increased amount of) thermal radiation with the circuit arrangement, which thermal radiation is directed at the section of the fixing member to cause the deformation of the section to disrupt the engagement between the first component and the second component as previously explained.

In order to safeguard people handling the components of the device during its disassembly, the device may further comprise a breaker switch straddling the first component and the second component and arranged to disrupt a power supply to the device upon removal of the second component from the first component. This ensures that the power to the circuitry within the device is automatically cut upon disassembly of the device, thereby avoiding the risk of electrocution by a person handling the disassembled device. Alternatively or additionally, the device may further comprise a thermal fuse in a power supply to the circuit arrangement such that the power supply to circuit arrangement is automatically cut upon the thermal fuse blowing because it has reached a predefined temperature, i.e. a temperature at which the section of the fixing member deforms to facilitate release of the first component from the second component.

In embodiments, the fixing member may comprise a thermoplastic polymer, and said section may define a reduced thickness portion of said thermoplastic polymer to ensure that the section deforms upon application of the thermal radiation. Alternatively, the section may comprise a bimetallic spring element deformable by such thermal radiation.

Instead of a bimetallic spring element, a shape memory material such as a shape-memory alloy or shape-memory polymer may be used for the section to ensure that the section can return to its original shape following the deformation of the section using thermal radiation.

The first component and the second component are housing components of the device, such that deformation of the fixing member provides access to the internals of the device by facilitating the opening of the housing of the device.

The device in preferred embodiments may be a lighting device such as a luminaire although in alternative embodiments other types of lighting devices, e.g. lamps or sensors, may be contemplated.

In accordance with another aspect, there is provided a method of disassembling a device comprising an assembly of components including a first component and a second component, the first component and the second component being housing components of the device; and a fixing member adapted to fix the first component to the second component, wherein the fixing member comprises a section deformable by thermal radiation such that the first component is releasable from the second component upon deformation of said section); and a circuit arrangement arranged to deliver the thermal radiation to the section, wherein the method comprises the steps of delivering thermal radiation to said section causing the section to deform; and releasing the second component from the first component. Such a method facilitates a cost-effective and straightforward disassembly of such a device, thereby facilitating the reuse of many components of the device at its end of life for example.

### BRIEF DESCRIPTION OF THE DRAWINGS

Embodiments of the invention are described in more detail and by way of non-limiting examples with reference to the accompanying drawings, wherein:
FIG. 1 schematically depicts an aspect of a device according to an embodiment;
FIG. 2 schematically depicts an aspect of a device according to an embodiment in more detail;
FIG. 3 schematically depicts an aspect of a device according to another embodiment;
FIG. 4 schematically depicts an aspect of a device according to yet another embodiment;
FIG. 5 schematically depicts an aspect of a device according to yet another embodiment;
FIG. 6 schematically depicts an exploded view of a lighting device according to an example embodiment;
FIG. 7 schematically depicts an aspect of the lighting device of FIG. 6 in further detail; and
FIG. 8 schematically depicts an aspect of the lighting device of FIG. 6 in still further detail.

### DETAILED DESCRIPTION OF THE EMBODIMENTS

It should be understood that the Figures are merely schematic and are not drawn to scale. It should also be understood that the same reference numerals are used throughout the Figures to indicate the same or similar parts.

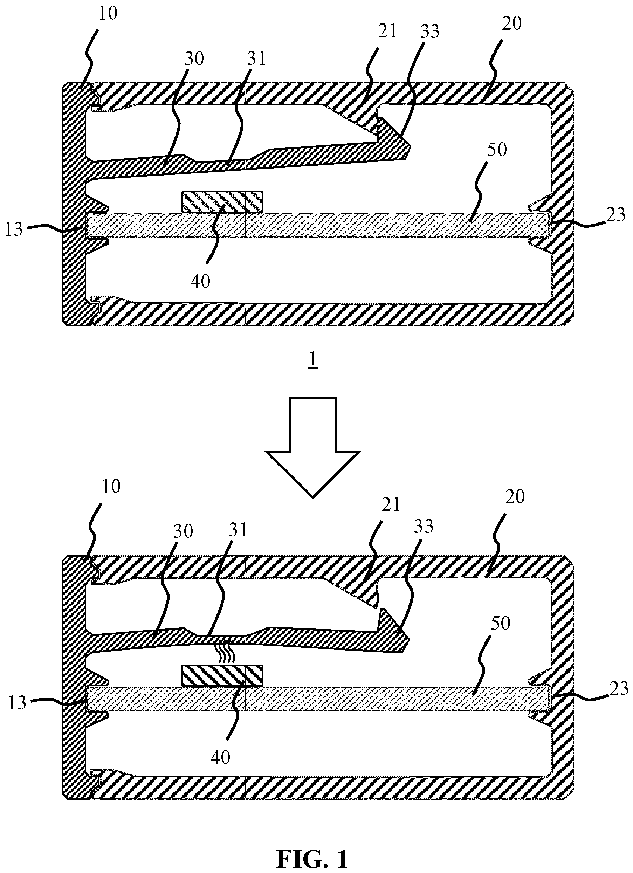

FIG. 1 schematically depicts several components of a device 1 such as a lighting device according to an embodiment. The device 1 comprises a housing including a first housing component 10 and a second housing component 20, which housing components may have any suitable shape and may be made of any suitable material, e.g. metal, metal alloy, a plastics or resin material, a composite material, and so on. Furthermore, it should be understood that although only two housing components 10, 20 are shown, the device 1 may have any suitable number of housing components, at least some of which may be assembled in accordance with the teachings of the present invention to be described in further detail below. In addition, it should be understood that teachings of the present invention are not limited to housing components per se but may be applied to any type of components that are to be assembled together, e.g. are to be kept in a fixed relationship relative to each other such as secured against each other.

As schematically depicted in FIG. 1, a fixing member 30 is mounted on the first component 10. In the context of the present application, the term 'mounted on' may refer to the fixing member 30 being attached to the first component 10 in any suitable manner as well as to the fixing member 30 forming an integral part of the first component 10. In the embodiment as schematically depicted in FIG. 1, the fixing member 30 comprises a thermoplastic polymer material, i.e. a polymer material that softens upon application of thermal radiation (heat) to the material, as is well-known per se. Any suitable thermoplastic polymer may be used to form the fixing member 30. The fixing member 30 comprises a terminal clamping member 33 that is shaped to engage with a feature 21 of the second component 20 such that the engagement between the clamping member 33 and the feature 21 secures the first component 10 against the second component 20, e.g. assembles the first component 10 on the second component 20, for example to form (part of) a housing of the device 1. For example, the terminal clamping member 33 may define a click feature or the like that clicks onto a feature 21 of the second component 20 in order to secure the first component 10 against a second component 20 as is well-known per se.

The fixing member 30 further comprises an intermediate section 31 having a reduced thickness such that upon application of thermal radiation to the fixing member 30, the intermediate section 31 defines a weak spot of the fixing member 30, i.e. is first to deform upon delivery of sufficient thermal radiation (heat) to the fixing member 30. Such thermal radiation may be delivered to the intermediate section 31 from an external source, e.g. an external heating element not forming part of the device 10, although in a particularly advantageous embodiment the device 10 comprises a circuit arrangement 40 that is thermally coupled to the intermediate section 31 such that upon engagement of the circuit arrangement 40 thermal radiation, e.g. heat, is generated by the circuit arrangement 40 and directed at the intermediate section 31. This is schematically depicted in the lower part of FIG. 1, in which the circuit arrangement 40 delivers the thermal radiation to the intermediate section 31 of the fixing member 30, causing the overall shape of the fixing member 30 to alter, thereby releasing the terminal clamping member 33 from the feature 21 of the second component 20 such that the first component 10 is no longer secured onto the second component 20 by the fixing member 30, thereby facilitating release of the first component 10 from the second component 20, e.g. by pulling apart the first component 10 and the second component 20.

The circuit arrangement 40 may be positioned relative to the fixing member 30 in any suitable manner. By way of non-limiting example, the circuit arrangement 40 may be mounted on a carrier 50 such as a PCB or the like, which carrier 50 may be mounted within the device 1 in any suitable manner. For example, as schematically depicted in FIG. 1, the first component 10 may include a first groove or channel 13 and the second component 20 may include a second groove or channel 23 opposite the first groove or channel 13 in which the carrier 50 may be mounted to secure the carrier 50 within the device 1. In FIG. 1, the circuit arrangement 40 is spatially separated from the intermediate region 31 of the fixing member 30 such that thermal radiation is conducted through the medium in between the circuit arrangement 40 and the fixing member 30, e.g. air.

The circuit arrangement 40 may form part of the electronics for controlling the device 1. For example, a lighting device 1 may comprise one or more solid state lighting elements, e.g. LEDs, under control of such electronics, e.g. driver circuits or the like. The circuit arrangement 40 for example may include a heating element such as a SMD resistor, a reverse polarity circuit such as a reverse polarity diode or the like, which may be operated by the provision of an appropriate voltage, e.g. an overvoltage or a reverse voltage, to trigger the generation of thermal radiation by such a heating element. Such a heating element in some embodiments may be connected to a dedicated connector such that disassembly of the device 1 may be triggered by connecting the heating device to a power supply through such a dedicated connector. Alternatively, the heating element may be powered through the power supply of the device 1, in which case the device 1 may be configurable to switch between a normal operation mode and a disassembly mode, with the appropriate voltage being delivered to the heating element in the latter mode to cause the deformation of the fixing member 30 such that the first component 10 may be released from the second component 20 as explained in more detail above.

The device 1 may comprise a wireless communication unit coupled to the circuit arrangement 40, which wireless communication unit is adapted to receive wireless commands for switching the device 1 from a normal operating mode to a disassembly mode in which the circuit arrangement 40 generates the thermal radiation for deforming the fixing member 30 as explained in more detail above. Any suitable type of wireless signal may be used for this purpose, e.g. an optical signal such as a UV or IR signal, a radio wave, and so on. In addition, any suitable wireless communication protocol, e.g. Bluetooth, Wi-Fi, a near-field communication (NFC) protocol, and so on, may be deployed for this purpose.

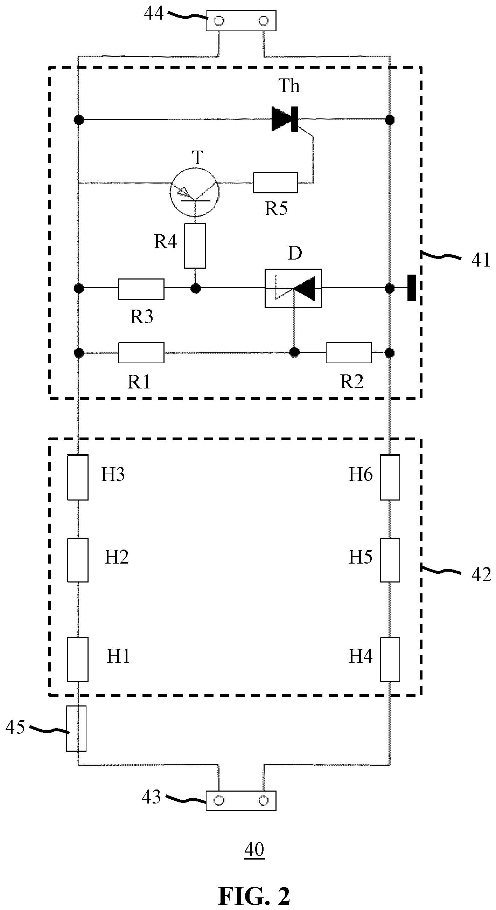

FIG. 2 schematically depicts an example embodiment of the circuit arrangement 40 in further detail. The circuit arrangement 40 in this example embodiment comprises a crowbar circuit 41 in series with a heating stage 42 between connectors 43 and 44. The crowbar circuit 41 for example may be deployed for overvoltage protection of the device and 1 as is well-known per se. Such a crowbar circuit may comprise any suitable number of components, such as resistors R1-R5, transistor T, thyristor Th and diode D in the example embodiment of the crowbar circuit 41. The heating stage 42 may comprise any suitable number of heating resistors, here six heating resistors H1-H6 in series connection are shown by way of non-limiting examples only, which heating resistors may function as ballasting resistors, e.g. for a LED assembly, during normal operation of the circuit arrangement 40. Other suitable arrangements, e.g. having a different number of heating resistors, having heating resistors in parallel rather than in series, or having different types of heating elements, will be immediately apparent to the skilled person. In order to trigger the deformation of the fixing member 30 during disassembly of the (lighting) device 1, an overvoltage may be deployed at the input connector 43, which overvoltage facilitates the delivery of a sufficient current supply to the heating resistors H1-H6 to cause the generation of the thermal radiation by these heating resistors to deform the fixing member 30.

In an embodiment, a thermal fuse 45 may be present between the heating stage 42 and the power supply to the circuit arrangement 40, e.g. between the heating stage 42 and the input connector 43 as schematically depicted in FIG. 2, which thermal fuse 45 may be designed such that the fuse is broken or blown at a temperature at which deformation of the fixing member 30 has been achieved. This is to ensure that upon the first component 10 becoming releasable from the second component 20 due to the deformation of the fixing member 30 as explained in more detail above, the power supply to the circuit arrangement 40 is disrupted by the thermal fuse 45 blowing, thereby protecting the person accessing the internals of the device 1 upon its disassembly from exposure to live circuitry. Although not specifically shown, the device 1 may further comprise a breaker switch straddling the first component 10 and the second component 20, which breaker switch may cause the disruption of the power supply to the device 1 upon the first component 10 being removed from the second component 20. Such a breaker switch may be additional to or alternative to the thermal fuse 45. The thermal fuse 45 may further prevent hazardous temperature conditions from occurring, e.g. through failure of one or more electrical components or the like, during normal operation of the device.

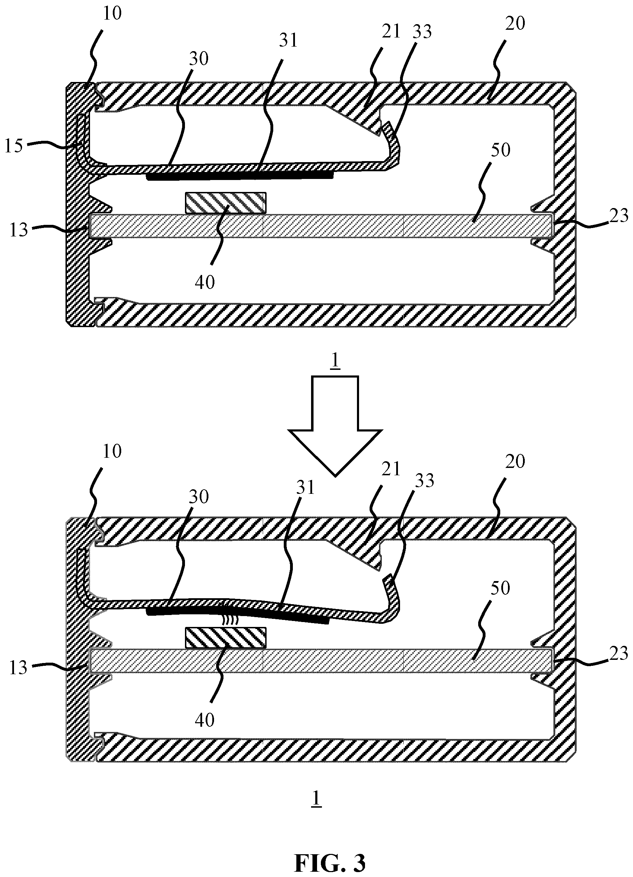

FIG. 3 schematically depicts an alternative embodiment of a device 1 such as a lighting device in which the fixing member 30 is a metal member having an intermediate section 31 defining a bimetallic spring formed by a bimetal composite. Such bimetallic structures are well-known per se and are therefore not described in further detail for the sake of brevity only; it suffices to say that any suitable bimetallic structure may be used as such a bimetallic spring portion in the fixing member 30. Upon delivery of thermal radiation to the bimetallic spring-based intermediate section 31 of the fixing member 30, the intermediate section 31 changes shape, thereby causing the release of the terminal clamping member 33 from the feature 21 on the second component 20, thereby disengaging the first component 10 from the second component 20 as previously explained. An advantage of using such a bimetallic spring-based intermediate section 31 is that the deformation of this section is reversible, thereby facilitating reuse of the fixing member 30. As an alternative to bimetallic materials, shape-memory materials such as shape-memory alloys and shape-memory polymers may be deployed as the intermediate section 31. Such shape-memory materials are well-known per se and are therefore not described in further detail for the sake of brevity only. It suffices to say that any suitable shape-memory material may be deployed as the intermediate section 31.

The fixing member 30 may be mounted in the first component 10 in any suitable manner. For example, the first component 10 may comprise a recess 15 in which a portion of the fixing member 30 may be mounted and secured in any suitable manner, e.g. using an adhesive or the like. Alternatively, the fixing member 30 may be moulded into the first component 10, for example in the case of the first component 10 being a plastics component.

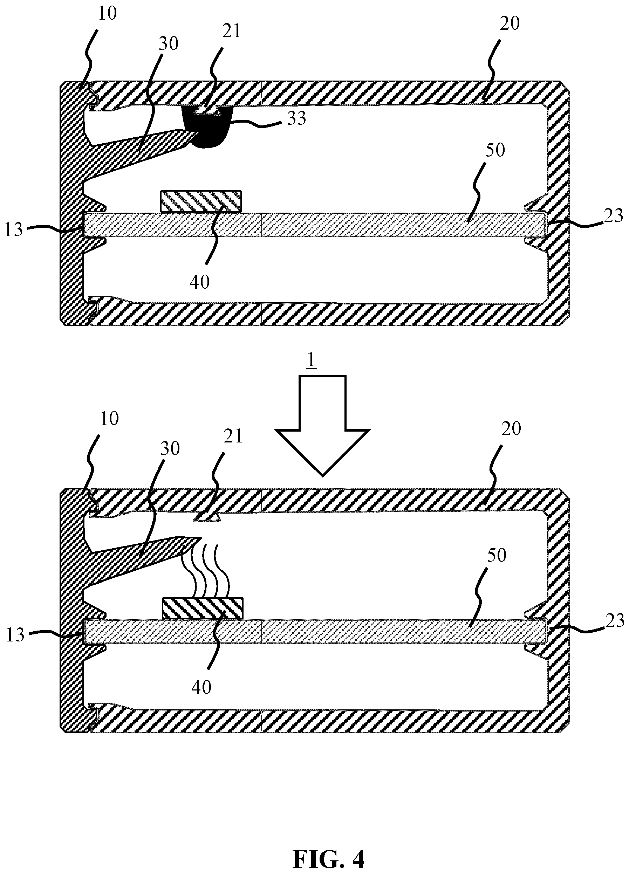

FIG. 4 schematically depicts yet another alternative embodiment of a device 1, e.g. a lighting device 1, in which a terminal portion 33 of the fixing member 30 is a volume of an adhesive material, e.g. a glue or the like, which secures the fixing member 30 against the feature 21 of the second component 20. In this embodiment, the adhesive material portion 33 may be removed by deployment of thermal radiation to the adhesive material portion 33 to melt this portion, thereby releasing the fixing member 30 from the feature 21 of the second component 20 and facilitating release of the first component 10 from the second component 20 in a disassembly process of the device 1. Any suitable adhesive material may be used for the adhesive material portion 33. As shown in FIG. 4, the thermal radiation may be delivered by the previously described circuit arrangement 40 or alternatively may be delivered using an external heat source, e.g. by guiding hot air through the device 1 in order to melt the adhesive material portion 33. As will be readily understood by the skilled person, the various components of the device 1 in the embodiment schematically depicted in FIG. 4 also facilitate multiple disassembly and reassembly cycles as the adhesive material portion 33 may be destroyed and subsequently replaced by a fresh adhesive material portion 33 in such cycles.

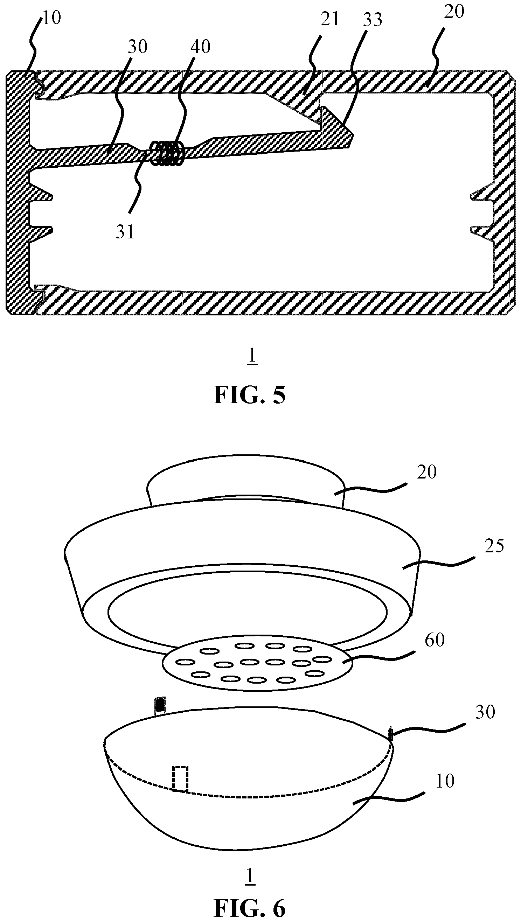

FIG. 5 schematically depicts yet another alternative embodiment of a device 1 such as a lighting device in which the circuit arrangement 40 is in physical contact with the intermediate section 31 of the fixing member 30. Specifically, the circuit arrangement 40 may comprise a heating coil wrapped around the intermediate section 31 to deliver thermal radiation, i.e. heat, to the intermediate section 31 to cause the deformation of the fixing member 30 as explained in more detail above.

At this point, it is noted that instead of the delivery of thermal radiation to the fixing member 30 in order to cause its deformation, alternatives exist. For example, the fixing member 30 may be a magnetic spring or the like responsive to the application of a magnetic field to the fixing member 30. In such an example, the circuit arrangement 40 may be adapted to generate such a magnetic field causing the magnetic fixing member 30 to be attracted towards the circuit arrangement 40, thereby causing the release of the terminal clamping member 33 from the feature 21 of the second component 20 and facilitating the disassembly of the device 1. Other suitable examples of such a magnetic fixing member 30 will be immediately apparent to the skilled person.

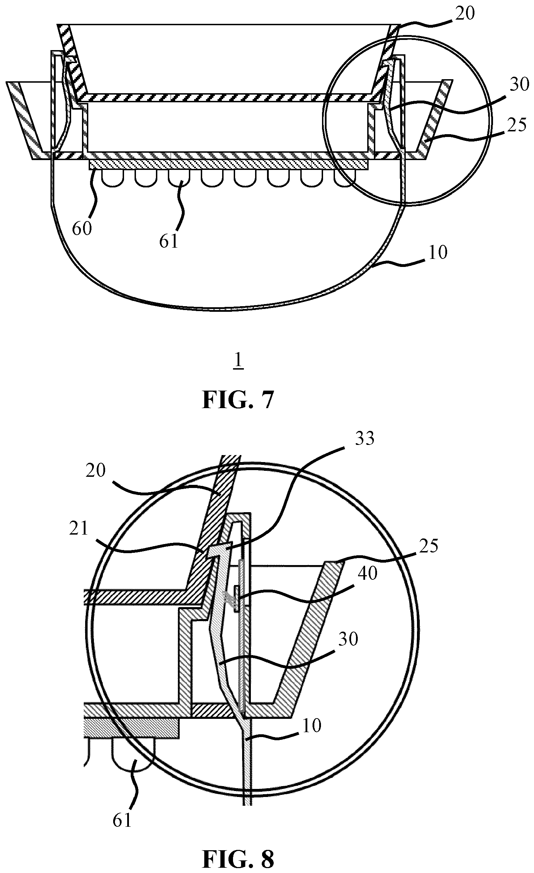

In addition, it should be understood that teachings of the present invention may be applied to any suitable type of assembled device, including but not limited to a lighting device such as a luminaire or a lamp. A non-limiting example of such a lighting device 1 is schematically depicted in FIG. 6, which depicts an exploded view of the lighting device 1. A cross-sectional view of the lighting device 1 is schematically depicted in FIG. 7. The lighting device 1 comprises a first component 10 in the form of a light exit portion, e.g. a translucent or transmissive cap or the like, which first component 10 comprises a plurality of fixing members 30, here in the form of spring clip features. The first component 10 forms part of the housing of the lighting device 1, which housing is further formed by housing components 20 and 25. A carrier 60 including a plurality of solid state lighting elements 61 may be mounted within the housing such that light emitted by the solid state lighting elements 61 exits the lighting device 1 through the light exit portion, i.e. through the first component 10.

FIG. 8 schematically depicts a magnified detail of the cross-sectional view within the circle in FIG. 7. In this magnified detail, the interaction or engagement of the terminal clamping member 33, e.g. a hook-shaped end portion of the spring clip fixing member 30 is shown to slot into a feature 21, e.g. a recess or the like, on the housing component 20 of the lighting device 1. The circuit arrangement 40, e.g. a heating element or the like, is arranged in thermal coupling with an intermediate section of the spring clip fixing member 30 such that upon delivery of thermal radiation to this intermediate section, the spring clip fixing member 30 deforms, causing the terminal clamping member 33 to release from the feature 21 such that the lighting device 1 may be disassembled due to the fact that the first housing component 10 is no longer secured against the second housing component 20.

## Claims

1. A device (1) comprising:
an assembly of components including a first component (10) and a second component (20), the first component (10) and the second component (20) being housing components of the device (1);
a fixing member (30) adapted to fix the first component (10) to the second component (20), wherein the fixing member (30) comprises a section (31, 33) deformable by thermal radiation such that the first component (10) is releasable from the second component (20) upon deformation of said section (31, 33); and
a circuit arrangement (40) arranged to deliver the thermal radiation to the section (31, 33).

2. The device (1) of claim 1, wherein the fixing member (30) is mounted on the first component (10) and includes a terminal clamping member (33) adapted to engage with the second component (20), and wherein the section is an intermediate section (31) of the fixing member (30) such that its deformation is adapted to cause the clamping member (33) to disengage from the second component (20).

3. The device (1) of claim 1, wherein the circuit arrangement (40) is spatially separated from the section (31, 33).

4. The device (1) of claim 1, wherein the circuit arrangement (40) is in physical contact with the section (31).

5. The device (1) of claim 1, wherein the circuit arrangement (40) has a first mode of operation in which the circuit arrangement (40) is adapted to deliver at least part of the functionality of the device (1), and a second mode of operation in which the circuit arrangement (40) is adapted to deliver the thermal radiation to the section (31, 33).

6. The device (1) of claim 5, wherein the circuit arrangement (40) is exposed to a higher voltage in the second mode of operation compared to the first mode of operation.

7. The device (1) of any of claims 1-6, further comprising a breaker switch straddling the first component (10) and the second component (20) and arranged to disrupt a power supply to the device (1) upon release of the second component (20) from the first component (10).

8. The device (1) of any of claims 1-7, further comprising a thermal fuse (45) in a power supply to the circuit arrangement (40).

9. The device (1) of any of claims 1-8, wherein the fixing member (30) comprises a thermoplastic polymer, and wherein said section (31) defines a reduced thickness portion of said thermoplastic polymer.

10. The device (1) of any of claims 1-9, wherein the section (31) comprises a bimetallic spring element or a shape memory material.

11. The device (1) of any of claims 1-10, wherein the device (1) is a lighting device.

12. A method of disassembling a device (1), wherein the device (1) comprises:
an assembly of components including a first component (10) and a second component (20), the first component (10) and the second component (20) being housing components of the device (1);
a fixing member (30) adapted to fix the first component (10) to the second component (20), wherein the fixing member (30) comprises a section (31, 33) deformable by thermal radiation such that the first component (10) is releasable from the second component (20) upon deformation of said section (31, 33); and
a circuit arrangement (40) arranged to deliver the thermal radiation to the section (31, 33),
wherein the method comprises the steps of:
delivering thermal radiation to said section (31, 33) by the circuit arrangement (4) thereby causing the section (31, 33) to deform; and
releasing the second component (20) from the first component (10).

## Patentansprüche

1. Vorrichtung (1), umfassend:
eine Anordnung von Komponenten, welche eine erste Komponente (10) und eine zweite Komponente (20) beinhaltet, wobei die erste Komponente (10) und die zweite Komponente (20) Gehäusekomponenten der Vorrichtung (1) sind;
ein Befestigungselement (30), welches adaptiert ist, um die erste Komponente (10) an der zweiten Komponente (20) zu befestigen, wobei das Befestigungselement (30) einen Abschnitt (31, 33) umfasst, welcher durch Wärmestrahlung verformbar ist, sodass die erste Komponente (10) bei Verformung des Abschnitts (31, 33) von der zweiten Komponente (20) abnehmbar ist; und
eine Schaltungsanordnung (40), welche angeordnet ist, um die Wärmestrahlung an den Abschnitt (31, 33) zu liefern.

2. Vorrichtung (1) nach Anspruch 1, wobei das Befestigungselement (30) auf der ersten Komponente (10) montiert ist und ein Anschlussklemmelement (33) beinhaltet, welches adaptiert ist, um in die zweite Komponente (20) einzugreifen, und wobei der Abschnitt ein Zwischenabschnitt (31) des Befestigungselements (30) ist, sodass seine Verformung adaptiert ist, um das Klemmelement (33) zu veranlassen, nicht mehr in die zweite Komponente (20) einzugreifen.

3. Vorrichtung (1) nach Anspruch 1, wobei die Schaltungsanordnung (40) von dem Abschnitt (31, 33) räumlich getrennt ist.

4. Vorrichtung (1) nach Anspruch 1, wobei die Schaltungsanordnung (40) mit dem Abschnitt (31) in physikalischem Kontakt ist.

5. Vorrichtung (1) nach Anspruch 1, wobei die Schaltungsanordnung (40) einen ersten Betriebsmodus, in welchem die Schaltungsanordnung (40) adaptiert ist, um zumindest einen Teil der Funktionalität der Vorrichtung (1) zu liefern, und einen zweiten Betriebsmodus, in welchem die Schaltungsanordnung (40) adaptiert ist, die Wärmestrahlung an den Abschnitt (31, 33) zu liefern, aufweist.

6. Vorrichtung (1) nach Anspruch 5, wobei die Schaltungsanordnung (40) in dem zweiten Betriebsmodus einer höheren Spannung ausgesetzt ist als in dem ersten Betriebsmodus.

7. Vorrichtung (1) nach einem der Ansprüche 1-6, weiter einen Unterbrecherschalter umfassend, welcher die erste Komponente (10) und die zweite Komponente (20) spreizt und angeordnet ist, um eine Stromversorgung zu der Vorrichtung (1) zu unterbrechen, wenn die zweite Komponente (20) von der ersten Komponente (10) freigegeben wird.

8. Vorrichtung (1) nach einem der Ansprüche 1-7, weiter eine Thermosicherung (45) in einer Stromversorgung zu der Schaltungsanordnung (40) umfassend.

9. Vorrichtung (1) nach einem der Ansprüche 1-8, wobei das Befestigungselement (30) ein thermoplastisches Polymer umfasst, und wobei der Abschnitt (31) einen Abschnitt mit reduzierter Dicke des thermoplastischen Polymers definiert.

10. Vorrichtung (1) nach einem der Ansprüche 1-9, wobei der Abschnitt (31) ein Bimetallfederelement oder ein Formgedächtnismaterial umfasst.

11. Vorrichtung (1) nach einem der Ansprüche 1-10, wobei die Vorrichtung (1) eine Beleuchtungsvorrichtung ist.

12. Verfahren zum Auseinandernehmen einer Vorrichtung (1), wobei die Vorrichtung (1) umfasst:
eine Anordnung von Komponenten, welche eine erste Komponente (10) und eine zweite Komponente (20) beinhaltet, wobei die erste Komponente (10) und die zweite Komponente (20) Gehäusekomponenten der Vorrichtung (1) sind;
ein Befestigungselement (30), welches adaptiert ist, um die erste Komponente (10) an der zweiten Komponente (20) zu befestigen, wobei das Befestigungselement (30) einen Abschnitt (31, 33) umfasst, welcher durch Wärmestrahlung verformbar ist, sodass die erste Komponente (10) bei Verformung des Abschnitts (31, 33) von der zweiten Komponente (20) abnehmbar ist; und
eine Schaltungsanordnung (40), welche angeordnet ist, um die Wärmestrahlung an den Abschnitt (31, 33) zu liefern,
wobei das Verfahren die folgenden Schritte umfasst:
Liefern von Wärmestrahlung an den Abschnitt (31, 33) durch die Schaltungsanordnung (4), wodurch der Abschnitt (31, 33) zum Deformieren veranlasst wird; und
Freigeben der zweiten Komponente (20) aus der ersten Komponente (10).

## Revendications

1. Dispositif (1) comprenant :
un ensemble de composants incluant un premier composant (10) et un second composant (20), le premier composant (10) et le second composant (20) étant des composants de logement du dispositif (1) ;
un élément de fixation (30) adapté pour fixer le premier composant (10) au second composant (20), dans lequel l'élément de fixation (30) comprend une section (31, 33) pouvant être déformée par rayonnement thermique de telle sorte que le premier composant (10) peut être libéré du second composant (20) lors de la déformation de ladite section (31, 33) ; et
un agencement de circuit (40) agencé pour délivrer le rayonnement thermique à la section (31, 33).

2. Dispositif (1) selon la revendication 1, dans lequel l'élément de fixation (30) est monté sur le premier composant (10) et inclut un élément de serrage de borne (33) adapté pour se mettre en prise avec le second composant (20) et dans lequel la section est une section intermédiaire (31) de l'élément de fixation (30) de telle sorte que sa déformation est adaptée pour amener l'élément de serrage (33) à se mettre hors prise du second composant (20).

3. Dispositif (1) selon la revendication 1, dans lequel l'agencement de circuit (40) est séparé dans l'espace de la section (31, 33).

4. Dispositif (1) selon la revendication 1, dans lequel l'agencement de circuit (40) est en contact physique avec la section (31).

5. Dispositif (1) selon la revendication 1, dans lequel l'agencement de circuit (40) a un premier mode de fonctionnement dans lequel l'agencement de circuit (40) est adapté pour délivrer au moins une partie de la fonctionnalité du dispositif (1), et un second mode de fonctionnement dans lequel l'agencement de circuit (40) est adapté pour délivrer le rayonnement thermique à la section (31, 33).

6. Dispositif (1) selon la revendication 5, dans lequel l'agencement de circuit (40) est exposé à une tension plus élevée dans le second mode de fonctionnement que dans le premier mode de fonctionnement.

7. Dispositif (1) selon l'une quelconque des revendications 1 à 6, comprenant en outre un disjoncteur de surcharge chevauchant le premier composant (10) et le second composant (20) et agencé pour interrompre une alimentation électrique du dispositif (1) lors de la libération du second composant (20) du premier composant (10).

8. Dispositif (1) selon l'une quelconque des revendications 1 à 7, comprenant en outre un fusible thermique (45) dans une alimentation électrique de l'agencement de circuit (40).

9. Dispositif (1) selon l'une quelconque des revendications 1 à 8, dans lequel l'élément de fixation (30) comprend un polymère thermoplastique, et dans lequel ladite section (31) définit une partie d'épaisseur réduite dudit polymère thermoplastique.

10. Dispositif (1) selon l'une quelconque des revendications 1 à 9, dans lequel la section (31) comprend un élément de ressort bimétallique ou un matériau à mémoire de forme.

11. Dispositif (1) selon l'une quelconque des revendications 1 à 10, dans lequel le dispositif (1) est un dispositif d'éclairage.

12. Procédé de démontage d'un dispositif (1), dans lequel le dispositif (1) comprend :
un ensemble de composants incluant un premier composant (10) et un second composant (20), le premier composant (10) et le second composant (20) étant des composants de logement du dispositif (1) ;
un élément de fixation (30) adapté pour fixer le premier composant (10) au second composant (20), dans lequel l'élément de fixation (30) comprend une section (31, 33) pouvant être déformée par rayonnement thermique de telle sorte que le premier composant (10) peut être libéré du second composant (20) lors de la déformation de ladite section (31, 33) ; et
un agencement de circuit (40) agencé pour délivrer le rayonnement thermique à la section (31, 33),
dans lequel le procédé comprend les étapes suivantes :
délivrance du rayonnement thermique à ladite section (31, 33) par l'agencement de circuit (4) amenant ainsi la section (31, 33) à se déformer ; et
libération du second composant (20) du premier composant (10).
